# EUROPEAN PATENT SPECIFICATION

(11) **EP 0 396 768 B1**
(45) Date of publication and mention of the grant of the patent: **23.07.1997**
(21) Application number: 89911406.0
(22) Date of filing: 11.10.1989
(51) Int. Cl.: G03F 1/00

(54) **PATTERN CORRECTION METHOD**
MUSTER-KORREKTURVERFAHREN
PROCEDE DE CORRECTION DE MOTIFS

(30) Priority: 08.11.1988 JP 282083/88
(43) Date of publication of application: 14.11.1990
(73) Proprietor: Kyodo Printing Co., Ltd., Tokyo 112 (JP)
(72) Inventor: FURUKAWA, Tadahiro, Bunkyo-ku Tokyo 112 (JP); KIKUCHI, Toshiaki, Bunkyo-ku Tokyo 112 (JP); KONNO, Hitoshi, Bunkyo-ku Tokyo 112 (JP)
(74) Representative: Spoor, Brian
(86) International application number: JP8901041
(87) International publication number: WO9005326

(56) References cited:
- JP-A-61 122 605
- JP-A-63 313 158
- US-A- 4 200 668

## Description

The present invention relates to a method of retouching a pattern which is formed on one side of a substrate and which is in part defective. The invention is more particularly concerned with a method or technique for effectively retouching a relatively thick pattern having, for example, a thickness of the order of 0.5 µm - 1.5 µm or more. Accordingly, this invention is directed to a method more suitable for retouching a colour filter in, for example, a colour liquid-crystal display panel etc, rather than a photomask which is used in the manufacture of a semiconductor device or the like, e.g. as acknowledged below.

It is generally known to retouch defects on a photomask, the necessity for retouching increasing as the photomask increases in area.

The way in which the pattern on the photomask is retouched, is also applied to retouching in other pertinent fields, for example, a colour filter or the like in a colour liquid-crystal display panel. However, such techniques are common to each other in retouching a pattern formed on one side of a substrate and which is partially defective.

This is generally evident from US Patent no 4 200 668 (Segal et al) which relates to the repair of pinholes in a defective photomask, e.g. comprising a chromium film on a glass substrate such as used in the manufacture of integrated circuit patterns. An adhesive promoting film layer (e.g. siloxane) is deposited on the surface of the photomask followed by a solvent soluble photoresist layer. A window is then formed by a laser through the layers and photomask in the area of each pinhole and a metallic film is deposited on the exposed surfaces. Finally a solvent is applied to the photomask to remove the photoresist and cause the metallic film to be removed except at each window area.

However as will be evident this procedure differs from, and does not include, essential features of applicants invention as hereinafter described and claimed.

Japanese Patent Unexamined Publication (Kokai) No SHO 54-32978 also discloses a technique primarily for retouching pattern defects of a photomask in which a protective membrane or layer is formed at least on the pattern surface of the side of the substrate prior to illumination by a laser such that the side of the substrate is protected and whereby on laser illumination portions of the protective layer are prevented from scattering and from adhering to the remaining portions of the protective layer so that the remaining portions form new defects. In addition, Japanese Patent Unexamined Publication (Kokai) No SHO 62-191804discloses such a technique in which a laser having its wave length equal to or less than 1 µm is applied to remove foreign matter adhering to a colour filter, together with the construction substance of the colour filter, which is located adjacent the foreign matter.

Should the portions of the photomask or the colour filter, from which the foreign matter is removed, be left as they are, the portions are brought to falling conditions and form different defects. To this end, it is necessary to fill the falling portions with pattern material or other retouching materials. In retouching of a colour filter, particular consideration must be made to obtaining uniformity of the membrane thickness of the filled retouching material with the thickness of the past pattern or the original pattern.

In this respect, Japanese Patent Unexamined Publication (Kokai) No SHO 61-122605 discloses such a method in which breaking portions of pigments of a colour filter are retouched or restored, an entire side of a substrate including a pigment layer is first coated with a photoresist, then portions of the pigment layer including the breaking portions of the pigments are then removed together with the photoresist by illumination from a laser so as to expose a portion of the substrate. A pigment layer is then formed on the substrate by vacuum-deposition and, subsequently, residual photoresist is dissolved and removed. According to this method, it is possible to form, by vacuum-deposition, the pigment layer for retouching under the same condition as the past pigment layer to be retouched, thereby bringing the thickness of the pigment layer of the retouched portions substantially to the thickness of the past pattern.

In such a retouching technique of a colour filter, however, the retouching of the breaking portions of the pigments must be done for each colour, that is, the retouching must be done in numbers corresponding to the colours such that a first pattern is formed, the first pattern is subsequently retouched, a second pattern is then formed, the second pattern is subsequently retouched, and so on.

The inventors of this application have considered various methods which more easily conduct retouching of an article having a plurality of types of patterns such as a colour filter.

As a result, the inventors have provided a method in which, after the plurality of types of patterns have all been formed, these patterns are retouched at once. In this method retouching material is partially filled in a plurality of portions to be retouched and the pattern portions are different in type from each other, depending upon their place.

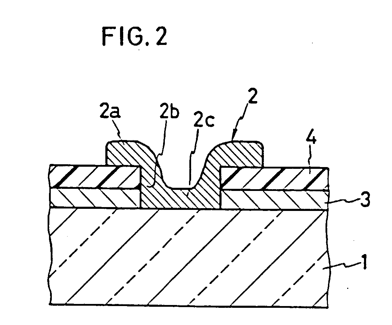

Figure 2 of the accompanying drawing shows a condition under which foreign matter is removed, and retouching material 2 is coated on the portion to be retouched in which one side of a substrate 1 is exposed. The retouching material 2 fills a defective portion of a pattern 3, and a part of the retouching material 2 adheres to an inner periphery of a retouching protective membrane 4 and an upper surface thereof.

A material section 2a on the retouching protective membrane 4 can be removed by removing the protective membrane 4. However, it is difficult to remove a material section 2b at a portion on the inner periphery of the protective membrane 4. As a result, there is a likelihood that the material section 2b at the inner peripheral portion of the protective membrane 4 is left in the form of a projection at a peripheral edge portion of a material section 2c which fills the defective portion, so that the projection forms a new defect. Where the retouching protective membrane 4 is of a thickness equal to or thicker than 1.5 µm, the thickness of the material section 2b remaining at the inner peripheral portion of the protective membrane 4 increases. Accordingly, when the pattern 3 itself is of large thickness per se such as a colour filter as compared with a photomask, the above-described problem becomes more difficult. Further, in the case of a colour filter, the projection mentioned above causes the display quality to deteriorate so that its influence is large.

The present invention has been arrived at after consideration of the points described above. Thus it is an object of the invention to provide an improved retouching technique in which it is difficult for an article such as a projection to occur at a peripheral edge portion of retouching material such as an ink which is partially filled in a defective portion of a pattern. As a result retouching can be effectively carried out.

According to the present invention, there is provided a method of retouching a defective pattern formed on one side of a substrate for a colour filter having a plurality of colour picture elements in which the pattern is coated with a protective layer and a hole is made through said layer and pattern to expose the substrate only at the location of the or each defect so as to remove the latter, filling the or each hole with a retouching material which adheres to the substrate and then removing the protective layer with any excess retouching material,
characterised by the protective layer being provided by a retouching protective membrane which is either water soluble so as to be oil repellent or is oil soluble so as to be water repellent and wherein the retouching material consists of one or more inks which is or are of the same or similar colour to a corresponding colour picture element or elements and is only introduced locally into the or each hole to fill the latter, said retouching material being correspondingly oil soluble or water soluble so as to be repelled by the retouching protective membrane whereby adhesion of retouching material to the retouching protective membrane is at least considerably reduced especially at the inner peripheral portion thereof about the or each filled hole so that it is difficult for projection of retouching material to remain thereat.

In the case where the retouching protective membrane and the retouching material are, for example, such that the former is oil-repellent and the latter is oil-soluble, the retouching material is difficult to adhere to an inner periphery of the protective membrane when the retouching material is coated and, accordingly, it is difficult for an article in the form of a projection mentioned previously to remain.

At this time, it is desirable that the retouching protective membrane is formed as thin as possible. For instance, in the retouching of a colour filter, the protective membrane is coated on the entire surface of the pattern. For this reason, it is better that the thickness of the protective membrane is within a range of from 0.5 µm - 2.0 µm, more preferably, within a range of from 0.5 µm - 1.5 µm. Within this range, it is possible to restrain the height of the projection to a value equal to or less than 1.0 µm.

The invention will now be described by way of practical example by reference to the accompanying drawings in which:-
- Figures 1a to 1e: are a process diagram showing an embodiment of the invention; and
- Figure 2: is a partial cross-sectional view for explanation of a problem which is solved by the invention as already referred to.

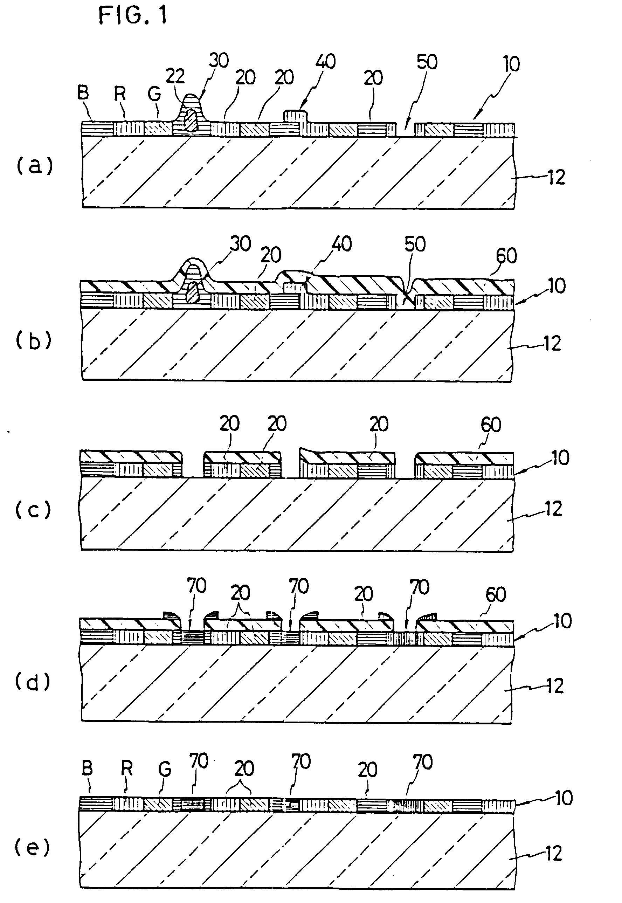

Reference is now made in turn to Figures 1a to 1e as follows:-

Figure 1a An article to be retouched is a colour filter 10. The colour filter 10 has colour picture elements 20 in three colours including red (R), green (G) and blue (B), which are the three primary colours, on one side of a planar support substrate 12 which is made from a transparent glass plate or the like. Light shielding patterns of black or the like may be included at portions of the boundary between the colour picture elements 20.

Three types of defects are seen at the colour picture elements 20. One is a defect 30 due to foreign matter 22, another is a defect 40 due to mixture of colours, and the other is a defect 50 due to falling of the picture element 20. The foreign matter 22 may be dust or a fragment of resin or the like which enters during manufacturing of the colour filter 10. The size of the foreign matter 22 may be a few micro metres (microns) to a few tens thereof. If the defect 30 is due to dust, a fragment of resin or the like, the display quality of a liquid-crystal display panel is deteriorated and, further, when the height of the defect 30 increases to a value equal to or higher than the gaps of liquid-crystal cells, the defect 30 also causes a short-circuit. The second defect 40 occurs due to transfer of another colour onto a portion other than a requisite portion, by contamination or the like of a photomask for manufacturing the colour filter, or of a printing plate. For instance, the second defect 40 is such a condition where the colour picture element 20 of red (R) partially rests on the colour picture element 20 of blue (B). Should the defect 40 increase to a value equal to or larger than 20 µm, for example, it is possible to actually see it. The larger the defect 40 is, the greater will be the deterioration of the quality of the display. The third defect 50 occurs due to imperfection in the transfer of resin for the colour filter, the photoresist or the like. The defect 50 also causes deterioration of the display quality.

Accordingly, defects such as 30, 40 and 50 lower the yield of the colour filter 10. In view of such defects and in order to improve the yield, or in order to obtain high-quality products, a retouching technique is utilised. In this connection, the colour filter 10 is made such that the material thereof is of macromolecular substance coloured by dyes or pigments. The colour filter 10 may be one which is made by any known method such as, for example, a dyeing method, a printing method, a method for patterning a colouring layer, or the like.

Figure 1b In retouching, the surface of the colour filter 10, including the above-described defects 30, 40 and 50, it is coated with a retouching protective membrane 60. The material used for the protective membrane 60, is selected so as not to be violated by the retouching material (ink) as subsequently described.

In the case where an oil soluble retouching ink is employed as the retouching material, a water soluble resin is used for the protective membrane 60. For instance, in the case where a colouring-polyimide retouching ink is used, gelatin, casein, PVA, gum arabic or the like is preferable for the protective membrane 60. A photoresist of solvent type is inadequate. It is also effective that an oil-repelling agent is added to the material for forming the protective membrane 60.

Further in order to enhance the sensibility or absorbency of a laser, dyes or a compound are added to the protective membrane 60 as the case may be.

Moreover, in the case where a water soluble retouching ink is used, an oil soluble resin is employed for the protective membrane 60. For instance, a gelatinous dye colour filter is retouched by gelatin having added thereto dyes, OBC (trade name: Tokyo Ohkasha) or SILITECT (trade name: Trylaner Technologies Inc) is preferable for the protective membrane 60. Among protective membranes of oil-solubility, SILITECT is superior as a material having a high water-repellence. Also in this case, it is effective that a water-repelling agent is added to the material which forms the protective membrane 60.

The retouching protective membrane 60 can be formed by coating. As the coating method, various methods can be utilised such as spin coating, roll coating, brushing, printing, spraying and the like. Further, the entire surface of the colour filter 10 may be coated with the protective membrane 60, or the peripheries of the respective defects may be partially coated with the protective membrane 60.

Figure 1c A laser is illuminated on the colour filter 10 which is coated with the retouching protective membrane 60, whereby the surface of the support substrate 12, that is, the glass, is exposed at the portions of the defects 30, 40 and 50.

As to the laser used in the illumination, this may be a CO₂ laser (wavelength: 10.6 µm), a laser within a visible range such as a second harmonic (wavelength: 0.53 µm) of a YAG:Nd laser, a xenon laser or the like, or a laser within the ultraviolet range such as an excimer laser or the like. Among them, a laser within the visible range and within the ultraviolet range is preferable. In case of the CO₂ laser, energy is absorbed and is heated at the surface portion of the support substrate 12 of the colour filter 10, so that the colour picture elements 20 and the retouching protective membrane 60 are partially torn off. However against this, and in the case of a laser within the visible range and the ultraviolet range, the colour picture elements 20 tend to absorb the energy of the laser, so that the removing efficiency of the colour picture elements 20 and the protective membrane 60 is superior. Accordingly, it is preferable also for the retouching protective membrane 60 that a wavelength portion of the laser used has an absorbency. In this connection, the portion of the defect 30 due to the foreign matter 22 has its surface in the form of a large protrusion or "mountain" centering around the foreign matter 22. Accordingly, it is preferable to remove a considerably wider area including the peripheral portion of the defect 30.

In connection with the above, a method of physically removing the defects by means of a needle or the like can also be utilised as a simple or easy method, though the method is not so highly accurate as the method which uses a laser.

Figure 1d The portions to be retouched, in which the surface of the support substrate 12 is exposed, are coated with retouching inks such as red, green and blue, so that the portions to be retouched are filled. Since the portions to be retouched are considerably small in area, a layer 70 of the retouching inks is inevitably formed also on the retouching protective membrane 60. However, the retouching protective membrane 60 is of thin form, or the protective membrane 60 is given such a property that the material of the protective membrane 60 repels the layer 70 of the retouching inks, whereby an adhering amount of such inks on the inner peripheral portion of the protective membrane 60 can be considerably reduced. In this regard the support substrate 12 is usually a glass plate. Where the portions have holes or bores formed therein by the laser, these are simply filled with the retouching inks, however, wettability of the retouching inks is different between the glass surface of the substrate 12 at the bottom of the bore and that of the surface of the retouching protective membrane 60. Accordingly, it can occur that the retouching inks do not uniformly adhere to the portions to be retouched with a uniform thickness. In this case, it is preferable that, prior to coating with the retouching inks, a pretreatment is given by dilution of the retouching inks, or by liquid in which resin of the retouching inks is diluted, or by dilution of the resin whereby the adhesiveness between the support substrate 12 and the retouching inks is improved.

Fundamentally, and as regards the inks of the retouching material, it is preferable that such inks are selected so as to be of the same material as that of colour picture elements 20 to be retouched. However, the inks are not limited to the same material of the colour picture element. Also it is preferable that the inks are the same in colour as far as possible. However, no problem occurs if the inks are only substantially the same in colour as each other. The retouching process can be simplified if a plurality of retouching portions positioned at a plurality of locations are filled with an ink of a single black colour or metal such as, for example, chromium or the like.

As to the filling method of the retouching inks, various methods are used such as brushing, printing, spraying, spin coating or the like. Among them, the spin coating method is most satisfactory in that the membrane thickness of the filling portions can be uniformly of the same thickness to that of the colour picture elements 20. In this spin coating method, an injection needle is used, for example, to drip a predetermined amount of retouching ink on the filling portions and, subsequently, the support substrate 12 is rotated, whereby the retouching ink of the filling portion is of uniform thickness to that of the colour picture elements 20. In this connection, since the retouching portion is extremely small in area, it is possible to coat the retouching ink partially and, accordingly, it is also possible to treat a plurality of colour inks at once, Of course, a portion, which is smaller in area than the size of the colour picture elements 20 and which does not cause any problem in the quality, does not require retouching.

Figure 1e The retouching protective membrane 60 is removed whereby the retouching inks 70 remain only on the portions to be retouched. As a method of removing the protective membrane 60, it is possible to use a method of washing the protective membrane 60 by a solvent or water, or by a method of tearing the protective membrane 60 from the surface of the substrate 12 by physical means, or the like.

Further, when the surface of the support substrate 12 is exposed by illumination of the laser, a case can occur where the edge portions of the respective defects and, as the case may be, the edge of each retouching portion exceeds, in height, the cell gaps of the liquid-crystal panel, for example, 5 µm. In this case, it is preferable that the laser is again applied to the portion having a high edge so as to remove it. If the laser is narrowed or reduced to a spot, for example, of the order of 2 µm - 3 µm, the removed area due to the laser is small, so that practically no problem occurs.

In connection with the above and as regards the retouching material, it is possible also to use a photo-sensitive resin consisting of achromatophilia. In this case, the photo-sensitive resin which fills in the locations to be retouched, is spot-exposed, whereby the photo-sensitive resin can remain only on the defective portions. Subsequently, the remaining photo-sensitive resin is dyed, and the retouching membrane is then removed, whereby the retouching is completed.

Moreover, in the case where material, in which a colouring agent such as dyes, pigments or the like is mixed with resin such as polyimide or the like is used as the pattern material and the retouching material; organic-inorganic transparent coating material such as, for example, JHR (trade name: Nippon Gosie Gomu Kabushiki Kaisha) can be used as the material of the retouching protective membrane 60. The JHR is superior as regards adhesiveness to the glass of the substrate 12, but is inferior as regards adhesiveness to coloured polyimide or the like. Accordingly, after the retouching material has been filled, it is possible to effectively remove the retouching protective membrane 60 by the use of an adhesive tape or the like.

As described above, and according to the invention, the retouching protective membrane 60 or the retouching material 70 is made of water-soluble material, while the other is made of oil-soluble material. Accordingly, no article or projection having a high back remains on the peripheral edge portion of the retouching material such as an ink or the like, which is filled into the retouching portions, so that it is possible to freely adjust the membrane thickness of the retouching portions thereby effectively retouching the pattern. In particular considerable advantages are obtained if the invention is applied to the pattern having a large membrane thickness, for example, to a colour filter for use in a colour liquid-crystal display panel. Further, the invention also obtains such advantages that, in the case where the invention is applied to retouching of an article having a plurality of types of patterns such as a colour filter, the plurality of types of patterns can simultaneously be retouched by a single retouching treatment.

### Example 1: Retouching of Colour Filter which uses Coloured Polyimide

An aqueous solution of 10% of PVA (polyvinyl alcohol) in which a slight amount of acid rhodamine B was dissolved, was coated on a colour filter 10 by means of spin coating. Subsequently, the aqueous solution was baked at 120°C for 5 (five) minutes, thereby forming a retouching protective membrane 60 having its thickness of 1.5 µm.

Subsequently, a second harmonic of a YAG:Nd laser was pulse-applied to a retouching portion having a defect, to form a bore in the retouching protective membrane 60 and the colour filter 10, thereby exposing the glass surface of the plate 12. A single drop of a polyimide retouching ink of oil-solubility for a red colour was dripped onto the retouching portion so as to smooth the latter by the spin coating. After baking at 150°C to harden the retouching ink the latter was subsequently rinsed with water. Then a smooth ink layer of a red colour remained only on the retouching location, and the remaining portion was rinsed together with the protective membrane. This was further baked at 250C to completely harden the retouching portion of polyimide, thereby completing the retouching operation.

### Example 2: Retouching of a Gelatinous Dyeing Colour Filter

SILITECT was coated as the retouching protective membrane 60 on a colour filter 10 by means of spraying. Subsequently, a xenon laser was applied to a retouching portion having a defect to form a bore, thereby exposing the glass surface of the plate 12.

A retouching ink layer for a blue colour, in which blue dyes were added to a gelatinous aqueous solution, was formed by means of spin coating. After air drying, the SILITECT layer 60 was peeled off from the colour filter 10 by the use of an adhesive tape. At the time of this peeling, the excess ink layer was also removed together with the SILITECT layer. Baking was then effected at 160°C to harden the retouching ink, thereby completing the retouching operation.

At this time, since the SILITECT was coated by means of spraying, the coating was considerably thickened. Since, however, the SILITECT per se is water-repellent, no problem occurs at a projection around the peripheral edge portion of the retouching pattern.

### INDUSTRIAL APPLICABILITY

As described above, the invention is useful as a retouching technique of a pattern in a photomask, a colour filter or the like. Particularly, the invention is preferable for retouching of an article having a plurality of patterns each of which is relatively large in membrane thickness, like the colour filter.

## Claims

1. A method of retouching a defective pattern formed on one side of a substrate for a colour filter having a plurality of colour picture elements in which the pattern is coated with a protective layer and a hole is made through said layer and pattern to expose the substrate only at the location of the or each defect so as to remove the latter, filling the or each hole with a retouching material which adheres to the substrate and then removing the protective layer with any excess retouching material, characterised by the protective layer being provided by a retouching protective membrane (60) which is either water soluble so as to be oil repellent or is oil soluble so as to be water repellent and wherein the retouching material (70) consists of one or more inks which is or are of the same or similar colour to a corresponding colour picture element or elements (20) and is only introduced locally into the or each hole to fill the latter, said retouching material (70) being correspondingly oil soluble or water soluble so as to be repelled by the retouching protective membrane (60) whereby adhesion of retouching material (70) to the retouching protective membrane (60) is at least considerably reduced especially at the inner peripheral portion thereof about the or each filled hole so that it is difficult for projection of retouching material (70) to remain thereat.

2. A method according to claim 1 wherein the defective pattern is entirely coated with the retouching protective membrane (60) or is only partially coated therewith i.e. at the or each defect location.

3. A method according to claim 1 or 2 wherein where the retouching protective membrane (60) is water soluble an oil repelling agent is added to it and where the retouching protective membrane is oil soluble a water repelling agent is added thereto.

4. A method according to any of claims 1, 2 or 3 wherein the retouching procedure is effected at a plurality of defect locations of one or more patterns substantially simultaneously.

5. A method according to any of the preceding claims wherein after introduction of the retouching material (70) locally into the or each hole through the retouching protective membrane (60) and pattern to the substrate (12), such as by spin coating, the substrate (12) is then rotated whereby the retouching material (70) in the or each hole is made of substantially uniform thickness to that of the colour picture element or elements (20).

6. A method according to any of the preceding claims wherein a predetermined amount of the retouching material (70) is dripped such as by means of an injection needle into the or each said hole through the retouching protective membrane (60) and pattern to the substrate (12).

7. A method according to any of the preceding claims wherein prior to introduction locally into the or each said hole, the retouching material (70) is given a pretreatment whereby its adhesiveness with the substrate (12) is increased.

8. A method according to claim 7 wherein the pretreatment is effected by dilution of the retouching material (70) or by dilution of liquid in which resin of the retouching material (70) is contained or by dilution of the resin itself.

9. A method according to any of the preceding claims wherein after introduction of the retouching material (70) into the or each said hole, the retouching protective membrane (60) is removed from the pattern by means of washing the membrane (60) with a solvent or water, or, particularly in the case of a thin membrane (60), by tearing it from the pattern or by removing it therefrom by means of adhesive tape.

10. A method according to any of the preceding claims wherein the thickness of the retouching protective membrane (60) is of the order of 0.5 µm - 2.0 µm.

11. A method according to any of the preceding claims wherein the or each said hole through the retouching protective membrane (60) and pattern to the substrate (12) is made by means of a laser operating at a wavelength which is absorbed by the retouching protective membrane (60).

12. A method according to claim 11 wherein any remaining projecting edge portion of a defect or of the retouching material (70) from the pattern colour picture element or elements (20) is or are removed by further laser treatment.

13. A method according to any of the preceding claims 1 to 10 wherein a needle or the like is employed for physically effecting defect removal.

## Patentansprüche

1. Verfahren zum Ausbessern eines fehlerhaften Musters, das auf einer Seite eines Substrats für einen Farbfilter gebildet ist, der eine Vielzahl von Farbfilterelementen hat, in denen das Muster mit einer schützenden Schicht bedeckt ist, und ein Loch durch die Schicht und das Muster gemacht wird, um das Substrat nur an der Stelle des oder von jedem Fehler freizulegen, um den letztgenannten zu entfernen, Füllen des oder von jedem Loch mit einem Ausbesserungsmaterial, das an dem Substrat haftet, und dann Entfernen der schützenden Schicht mit irgendeinem überschüssigen Ausbesserungsmaterial, darin gekennzeichnet, dass die schützende Schicht von einer ausbessernden schützenden Membran (60) geliefert wird, die entweder wasserlöslich ist, um ölabweisend zu sein, oder öllöslich ist, um wasserabweisend zu sein, und in dem das ausbessernde Material (70) aus einer oder mehreren Tinten besteht, die oder welche dieselbe oder eine ähnliche Farbe wie ein entsprechendes Farbbildelement oder -elemente (20) hat, und die nur örtlich in das oder jedes Loch eingeführt wird, um das letztgenannte zu füllen, wobei das Ausbesserungsmaterial (70) entsprechend öllöslich oder wasserlöslich ist, um von der ausbessernden schützenden Membran (60) abgewiesen zu werden, wobei Haftung des ausbessernden Materials (70) an der ausbessernden schützenden Membran (60) wenigstens beträchtlich verringert wird, insbesonders an dem inneren peripheren Teil davon um das oder jedes gefüllte Loch, so dass es für einen Vorsprung des ausbessernden Materials (70) schwierig ist, dort zu bleiben.

2. Verfahren nach Anspruch 1, in dem das fehlerhafte Muster ganz mit der ausbessernden schützenden Membran (60) bedeckt ist, oder nur teilweise damit bedeckt ist, d.h. an der oder jeder Fehlerstelle.

3. Verfahren nach Anspruch 1 oder 2, in dem der ausbessernde schützenden Membran (60) ein ölabweisendes Mttel zugegeben wird, wenn sie wasserlöslich ist, ihr, und der ausbessernden schützenden Membran ein wasserabweisendes Mittel zugegeben wird, wenn sie öllöslich ist.

4. Verfahren nach einem der Ansprüche 1, 2 oder 3, in dem die Ausbesserungsprozedur an einer Vielzahl von Fehlerstellen von einem oder mehreren Mustern im wesentlichen gleichzeitig bewirkt wird.

5. Verfahren nach einem der vorhergehenden Ansprüche, in dem nach der Einführung des Ausbesserungsmaterials (70) örtlich in das oder jedes Loch durch die ausbessernde schützende Membran (60) und das Muster zu dem Substrat (12) wie durch Schleuderbeschichten, das Substrat (12) dann gedreht wird, wobei das Ausbesserungsmaterial (70) in dem oder jedem Loch mit einer im wesentlichen gleichförmigen Dicke wie der des Farbbildelements oder -elemente (20) hergestellt wird.

6. Verfahren nach einem der vorhergehenden Ansprüche, in dem eine vorbestimmte Menge des Ausbesserungsmaterials (70) wie durch eine Einspritznadel in die oder jedes Loch durch die ausbessernde schützende Membrabn (60) und das Muster zu dem Substrat (12) getropft wird.

7. Verfahren nach einem der vorhergehenden Ansprüche, in dem vor der örtlichen Einführung in das oder jedes Loch dem Ausbesserungsmaterial (70) eine Vorbehandlung gegeben wird, wobei seine Haftfähigkeit an dem Substrat (12) erhöht wird.

8. Verfahren nach Anspruch 7, in dem die Vorbehandlung durch Verdünnung des ausbessernden Materials (70) oder durch Verdünnung von Flüssigkeit, in der Harz des ausbessernden Materials (70) enthalten ist, oder durch Verdünnung des Harzes selbst bewirkt wird.

9. Verfahren nach einem der vorhergehenden Ansprüche, in dem nach der Einführung des ausbessernden Materials (70) in das oder in jedes Loch die ausbessernde schützende Membran (60) von dem Muster durch Waschen der Membran (60) mit einem Lösungsmittel oder Wasser entfernt wird, oder, insbesonders im Fall einer dünnen Membran (60), durch Abreissen von dem Muster oder durch Entfernen davon durch ein Klebband.

10. Verfahren nach einem der vorhergehenden Ansprüche, in dem die Dicke der ausbessernden schützenden Membran (60) in der Grössenordnung von 0,5 µm - 2,0 µm liegt.

11. Verfahren nach einem der vorhergehenden Ansprüche, in dem das oder jedes Loch durch die ausbessernde schützende Membran (60) und das Muster zu dem Substrat (12) durch einen Laser hergestellt wird, der bei einer Wellenlänge arbeitet, die von der ausbessernden schützenden Membran (60) absorbiert wird.

12. Verfahren nach Anspruch 11, in dem irgendein verbleibendes vorspringendes Kantenteil eines Fehlers oder des ausbessernden Materials (70) von dem Musterfarbbildelement oder -elementen (20) durch weitere Laserbehandlung entfernt wird oder werden.

13. Verfahren nach einem der vorhergehenden Ansprüche 1 bis 10, in dem eine Nadel oder dergleichen benutzt wird, um Fehlerentfernung physikalisch zu bewirken.

## Revendications

1. Méthode de retouche de modèle défectueux formé d'un côté du substrat d/un filtre de couleur comportant une pluralité d'éléments d'image en couleur dont le modèle est revu d'une couche protectrice, un trou étant pratiqué dans ladite couche et le modèle pour exposer exclusivement le substrat à l'endroit ou aux endroits intéressés de telle façon à en éliminer la ou les défectuosités, pour boucher le ou les trous avec une matière de retouche qui colle au substrat, éliminant alors la couche protectrice avec toute matière de retouche excédentaire, caractérisé en ce que la couche protectrice est assurée sous forme d'une membrane protectrice (60) qui est soluble dans l'eau de façon à être résistante à l'huile ou soluble dans l'huile de façon à être hydrofuge et dont la matière de retouche (70) consiste d'une ou de plusieurs encres de couleur identique ou semblable à un ou plusieurs éléments d'image de couleur correspondante (20) et n'est introduite que localement dans le ou les trous à retoucher, ladite matière de retouche (70) étant soluble dans l'huile ou soluble dans l'eau de façon correspondante de telle manière à être repoussée par la membrane protectrice de retouche (60) suivant laquelle l'adhérence de la matière de retouche (70) à la membrane protectrice de retouche (60) est au minimum considérablement réduite surtout dans la portion à son pourtour intérieur du ou des trous ainsi remplis de façon telle qu'il serait difficile pour une projection de matière de retouche de rester en place.

2. Méthode selon la revendication 1 suivant laquelle le modèle défectueux est entièrement revêtu par la membrane protectrice de retouche (60) ou que n'en est que partiellement revêtue, c.à.d. à l'emplacement du ou des points défectueux.

3. Méthode selon la revendication 1 ou 2 suivant laquelle lorsque la membrane protectrice de retouche (60) est soluble dans l'eau un agent résistant à l'huile lui est ajouté et lorsque la membrane protectrice de retouche est soluble dans l'huile un agent hydrofuge lui est ajouté.

4. Méthode selon l'une ou l'autre des revendications 1, 2 ou 3 suivant laquelle le procédé de retouche est effectué dans une pluralité d'emplacements de défectuosités.

5. Méthode selon l'une ou l'autre des revendications précédentes, suivant laquelle après l'introduction locale de la matière de retouche (70) dans le ou les trous à travers la membrane protectrice de retouche (60) et le modèle jusqu'au substrat (12), tel que par le revêtement centrifuge, le substrat (12) est alors l'objet de rotation suivant laquelle la matière de retouche (70) dans le ou les trous se réalise en épaisseur essentiellement uniforme par rapport à celle de l'élément ou des éléments (20) d'image de couleur.

6. Méthode selon l'une ou l'autre des revendications précédentes, suivant laquelle un montant prédéterminé de matière de retouche (70) est égoutté par exemple par une aiguille d'injection dans ledit ou lesdits trous au travers de la membrane protectrice de retouche (60) et du modèle jusqu'au substrat (12).

7. Méthode selon l'une ou l'autre des revendications précédentes, suivant laquelle avant son introduction localisée dans ledit ou lesdits trous, la matière de retouche (70) subit un traitement préliminaire assurant une augmentation de son adhérence sur le substrat (12).

8. Méthode selon la revendication 7 suivant laquelle le traitement préliminaire est effectué par la dilution de la matière de retouche (70) ou la dilution de liquide dans lequel est contenue la résine de la matière de retouche (70) ou par dilution de la résine elle-même.

9. Méthode selon l'une ou l'autre des revendications précédentes, suivant laquelle suite à l'introduction de la matière de retouche (70) dans le ou les trous, la membrane protectrice de retouche (60) est éliminée du modèle par l'intermédiaire du nettoyage de la membrane (60) avec un solvant ou de l'eau, ou surtout en cas d'une membrane très fine (60) en la déchirant du modèle ou en l'éliminant au moyen de bande adhésive.

10. Méthode selon l'une ou l'autre des revendications précédentes, suivant laquelle l'épaisseur de la membrane protectrice de retouche (60) est de l'ordre de 0,5 µm -2,0 µm.

11. Méthode selon l'une ou l'autre des revendications précédentes, suivant laquelle le ou les trous dans la membrane protectrice de retouche (60) et le modèle (12) est pratiqué au moyen d'un laser fonctionnant à une longueur d'onde qui est absorbée par la membrane protectrice de retouche (60).

12. Méthode selon la revendication 11 suivant laquelle toute portion résiduelle ou autre en saillie de défectuosité ou de matière de retouche (70) depuis le ou les éléments (20) de modèle d'image en couleur est ou sont éliminées par traitement supplémentaire au laser.

13. Méthode selon l'une ou l'autre des revendications précédentes 1 à 10, suivant laquelle une aiguille ou autre est utilisée pour l'élimination physique de la défectuosité.
